# EUROPEAN PATENT APPLICATION

(11) **EP 4 624 946 A1**
(43) Date of publication of application: **01.10.2025**
(21) Application number: 24167828.3
(22) Date of filing: 29.03.2024
(51) Int. Cl.: G01R 31/00, G01R 31/58

(54) **A WIRE HARNESS AUTOMATED DIAGNOSIS SYSTEM AND METHOD**

(71) Applicant: Valeo Vision, 93012 Bobigny Cedex (FR)
(72) Inventor: BOISSIE, Kevin, 58000 Nevers (FR); MORSALI, Alireza, 94000 Creteil (FR)
(74) Representative: Valeo Visibility

(57) **Abstract**

The present disclosure provides for an automated wire harness diagnosis system and process for measuring the electrical characteristics of a wire harness in order to provide an estimate of the useful lifespan of the wire harness. Embodiments described herein may be deployed in a remanufacturing environment or in a manufacturing environment to provide statistically based estimates of the remaining useable lifetime of the wire harness, thus allowing to reduce costs and waste when producing wire harnesses within a circular economy environment.

## Description

The inventive concepts described herein relate generally to the domain of testing or measuring electrical components, especially during manufacturing. More particularly, embodiments described herein may be used to test electrical wire harnesses.

Cable harnesses are commonly used, inter alia, in the automotive, rail transportation and aviation industries, for example, to conduct electrical signals between electronic control units located at one place in a vehicle or aircraft to and from multiple electrical or electronic components located at other places in the vehicle or aircraft, bidirectionally. A cable harness, or wire harness, may include a bundle of individual connector wires of different types, each having different connectors, located at different positions along the harness depending on where in an installation and for which specific purpose each wire serves in connection to its corresponding component. Thus, different components and subassemblies located at different positions within the vehicle or aircraft may be properly interconnected via the wiring harness.

In a conventional motor vehicle installation, it is not uncommon for the vehicle to comprise scores of control units tasked with the regulation of an extensive array of sensors or other electronic elements throughout the vehicle, these control units and electronic elements being interconnected in one or several networks through hundreds of wires, whose cumulative length may approximate or exceed the magnitude of one kilometre, an assembly of conductive pathways may be organised into an entity commonly referred to as a wiring harness. It is of prime importance therefore, for reasons of safety, among others, that the wiring harness provide accurate and reliable connectivity between the various control units and electronic elements in the system.

Because of the pivotal role of wire harnesses, from the point of view of reliability, considerable effort is dedicated to their test and validation. Such tests include assessments of electrical continuity and may extend to verifying that the harness is properly connected to the relevant components. However, the reliability of the electronics systems incorporating a wire harness a mere short circuit or a broken wire; it also depends on the wire harness capability to maintain signal integrity without degradation during operation. Signal integrity in an electronics installation may become adversely impacted during operation due to potential wire harness degradation. This degradation could manifest in various forms, such as missing wire strands, compromised wire insulation, improperly formed connector crimp pins, or the presence of cuts or abrasions on a wire or its insulation. Considering the critical importance of maintaining optimum signal integrity, substantial investments are typically made in the rigorous testing of wire harnesses throughout their manufacturing process to ensure they meet the highest standards of performance and reliability. Generally, if a wire harness is identified as faulty during a test, it is discarded as the manufacturers adopt this approach to mitigate the risk of a system failure attributable to harness-related reliability issues over the lifespan of a system in which the harness is installed. For this reason, the practice of reworking faulty or reuing utilised, materials, is generally avoided within the industry, due to concerns about signal degradation issues in a system as a result of an imperfect wire harness.

Conversely, contemporary manufacturers are increasingly attuned to concerns related to waste and its environmental impacts. Wire harness components include many expensive, precious raw materials such as copper, aluminium or even silver. Harness components also include connectors and insulating materials, which may be made of plastics, rubber and/or fluoropolymers, the production of which poses challenges to ecological sustainability and contributes to rising manufacturing costs. For these reasons, the rejection of a faulty, and/or utilised wire harness will be financially burdensome and have a non-negligible impact on plastic pollution in the environment.

There is, therefore, a need to provide a solution for reutilisation, recycling or otherwise re-manufacturing of products such as wire harnesses, while simultaneously being able to guarantee the reliability of such reworked products.

It is known in the prior art, to provide continuity testers to verify that manufactured wire harnesses meet designed electrical specifications. However, before a continuity tester can be used, it must be connected to the harness and programmed with a wire list. Depending on the number of different types or models of wire harness a manufacturer provides, it may become prohibitively expensive to rely on this type of testing. It is essential to ensure that the tester operator, who is usually a human, connects the harness up to the tester in the proper fashion. This method is therefore prone to errors. Such testers also cannot guarantee the reliability of a harness in terms of view of signal degradation.

German patent application publication number DE102011087152A1 discloses a system that allows testing of different types of wire harnesses to be performed in an efficient manner. The harness to be tested comprises a number of plugs for connecting different wires to different control units and other components in the system in which the harness is to be installed. The test system features at least one first harness connector designed to interface with one or more plugs of the harness and further includes at least one further harness connector having test leads, with different groups of test leads being terminated with corresponding different test plugs for connecting to the various different other plugs of the harness. Thus, the tester may be programmed to provide different test patterns at different terminals of the harness in order to forward signals via the harness itself between the different terminals in the harness plugs. This provides a centralised approach for testing the wire harness, where signals are propagated throughout the harness to the points where they are needed. Each of the plugs may comprise its own controller.

Chinese utility patent application publication number CN213069014U describes testing a wire harness resistor by calculating its resistance through supplying a DC stimulus in the form of a current from a constant current source, via a switching module, to a wire harness under test. Using the switching module, the voltage is measured at two ends of the wiring harness under test and a calculation of the resistance of the wire harness is made.

It is recognised that AC electrical stimuli may be utilised to characterise transmission lines. The degradation of a signal due to certain defects in a cable can be measured using time domain reflectometry (TDR) techniques. However, in the case of a wire harness, having perhaps hundreds of wires, it would be necessary to be able to measure wire resistances in the order of a few milli-ohms. Known equipment for performing TDR analysis, capable of providing such resolution are prohibitively expensive for their use to be considered for testing wire harnesses. Testing using this technique would also be time consuming as each wire would need to be tested in turn. United States patent publication number US9250283B2 therefore proposes a custom-made tester including one or more TDR engines and a switching matrix, the tester being configured to sequentially apply a TDR stimulus to each of the wires in a cable harness under test, pin by pin and to collect the resulting TDR waveform data. The waveform data is analysed to determine whether the cable harness meets quality standards.

The environmental implications of insulation and connectors made of plastic, rubber, and fluoropolymers, coupled with the expense of copper and aluminium, underscore the necessity to develop a comprehensive approach to wire harness recycling and retrieval as opposed to continually manufacturing new harnesses. An approach to t wire harness (re)manufacturing that aligns more with the principles of a circular economy is required. Consequently, the concept of recycling and validating used wire harnesses as opposed to solely manufacturing new ones gains significance. While reusing manufactured wire harnesses presents clear economic advantages, along with the benefits with regard to the reduction of pollution and the avoidance of the accumulation of environmental waste, as mentioned previously, it is important to be able to ensure the safety and reliability of previously used wire harness systems. The failure of even just a single wire within a wire harness may lead to severe consequences, including that of fire risk. Consequently, rigorous testing and validation protocols are imperative for the recycling process as well as in the initial manufacturing phase, thus properly ensuring compliance with industry standards and norms. In view of the prior art, there remains a need for an environmentally friendly process for providing reliable wire harnesses for electronics environments wherein safety requirements are adequately guaranteed.

As aforementioned, aligned with the principles of circular economy in the field of the manufacture of electrical products such as wire harnesses, there is a requirement to reuse already existing materials, components and systems with the imperative to still ensuring safety. Indeed, wire harnesses, for example, are subject to wear and tear during their operational lifetime which can compromise their structural integrity and affect their electrical and/or mechanical performance. Within their operational environment they may be exposed to dynamic conditions that can lead to electrical or physical stress, corrosion, degradation of the insulation, certain of which may pose fire hasards. Consequently, reutilisation of used and aged wire harnesses is generally perceived to carry a risk, thus, preference is given to manufacturing new ones in the interest of safety. However, according to embodiments described herein a systematic approach for test and validation of wire harnesses enabling the characterisation of used or new one with the aim of predicting their useful lifetimes, thereby ensuring their safety for use. Thus, it becomes possible to challenge the previously widely accepted dogma that new products are invariably more reliable than used ones, allowing therefore to embrace a circular economy approach to the manufacture of products such as wire harnesses, thereby avoiding unnecessary environmental pollution and wasteful use of valuable components. By introducing an automated, scientifically grounded, systematic approach to guarantee the reliability of new or used product, these objectives can be achieved.

Embodiments outlined herein may be applied in a remanufacturing context, where quantification and estimation of the operational lifetime of a wire harness becomes crucial. Systems and methods detailed herein provide for advanced automated techniques for assessing wear and tear, stress, corrosion and insulation degradation in wire harnesses, offering a comprehensive characterisation and subsequent estimate of the lifetime of the harness. In the realm of remanufacturing, it is possible to employ such results to ensure that essential repairs can be carried out effectively, thus significantly extending the operational lifespan of wire harnesses and ensuring their safety for reuse.

An automated protocol is described for use in an environmentally friendly manufacturing process and at least one electronics hardware and software system. According to an embodiment, the hardware system may comprise a wire management subsystem configured to organise one or more of the wires into a predetermined configuration to be presented to a load characterisation subsystem configured to provide an electrical stimulus and to measure a response of the wires to the stimulus. By comparing the response of the harness to known responses from harnesses in different states of condition, an estimate of the reliable remaining lifetime of the harness under test may be made.

According to a first aspect, provision is made for an automated wire harness diagnosis system for diagnosing faults and/or for estimating a residual useful lifetime of a wire harness comprising a plurality of different wires for carrying power or electrical signals and one or more wire terminals or wire terminal groups at the ends of the plurality of wires, the automated wire harness diagnosis system comprising:
- a harness interface subsystem comprising a set of connectors configured to receive connection from at least one of the wire terminals or wire terminal groups of the wire harness;

According to the invention, the system further comprises:
- a load characterisation subsystem configured to provide an electrical stimulus to an electrical load across a test port of the load characterisation subsystem and to monitor a response of the electrical load to the electrical stimulus;
- a controller configured to control at least the load characterisation subsystem according to a predetermined automated wire harness diagnosis protocol; and
- a wire management subsystem configured to organise a plurality of the wires of the wire harness into a predetermined configuration to provide a suitable electrical load for the load characterisation subsystem, said predetermined configuration resulting in the plurality of wires being electrically connected in series with each other at the test port.

Preferably, by using a suitably configured wire management subsystem, all of the wires of the wire harness are presented at the test port in a configuration which effectively is equivalent to all of the wires of the harness being presented end to end in a series configuration at the test port.

According to one embodiment, a DC stimulus is provided to the load.

According to another embodiment, an AC stimulus is provided.

According to an embodiment, data analysis is performed on the monitored response of the harness under test, the data analysis involving classification of the results based on a trained machine learning model.

According to another aspect, provision is made for a method for diagnosing faults and/or for estimating a residual useful lifetime of a wire harness comprising a plurality of different wires for carrying power or electrical signals and one or more wire terminals or wire terminal groups at the ends of the plurality of wires using the system according to the wire harness diagnosis system described above, the method comprising:
- connecting all of the wire terminals or wire terminal groups of a wire harness to be tested to the connectors of the harness interface subsystem;
- connecting the harness interface subsystem to the wire management subsystem, said wire management subsystem being configured to present an electrical load at the test port, the load comprising all of the wires of the wire harness presented in an end to end series configuration of the wires;
- connecting the test port of the wire management subsystem to the test port of the load characterisation subsystem;
- programming the load characterisation subsystem to provide an electrical stimulus at the test port; and
- monitoring the response of the electrical load provided by the harness under test at the test port.

Embodiments described herein provide for a control loop involving proportional, integral and derivative factors using analogue means, thus bringing greatly improved precision while using an essentially analogue circuit to achieve voltage and current regulation functions for performing electrical characterisation of a passive load formed by a suitably configured wire harness.

According to a particular embodiment, provision is made for a precision resistance measuring circuit having a fast response time compared to a time constant characteristic of a load whose resistance is to be measured. Such embodiments may include a plurality of discreet or integrated electronics components configured to form a current mirror driven by a substantially constant current source having a controllable output voltage using a proportional integral derivative (PID) controller. Such embodiments provide for a finely tuneable constant current source having a wide output voltage range. In some embodiments, a pulse-width modulation system (PWM) may be used to provide switching to the PID controller.

Owing to embodiments described herein it is enabled to no longer merely assume that reworked or used product is inherently less reliable than newly manufactured product. The automated protocol guarantees that the recycled product is as reliable as a newly manufactured product. Although the automated protocol described herein may be used as part of a remanufacturing process, the automated protocol may also be applied to a process for manufacturing new product. Embodiments described herein contribute favourably to the responsible management of the energy consumption for manufacturing and and contribute to the decarbonisation.

The inventive concepts described herein will be more effectively perceived owing to the detailed description which follows and the accompanying drawings, provided as illustrative yet not exhaustive examples of embodiments of the inventive concepts described herein, namely:
[Fig.1a] illustrating an example of a wire harness which may be used in an automotive setting;
[Fig.1b] showing an electrical schematic representation of the wire harness shown in Figure 1a;
[Fig. 2] in which an embodiment of an automated wire harness diagnosis system is schematically represented;
[Fig. 3] in which an automated diagnosis protocol according to an embodiment described herein is illustrated; and
[Fig. 4] showing a current source according to an embodiment of a load characterisation subsystem which may be deployed in an embodiment of the wire harness diagnosis system may be deployed, the current source comprising a current mirror realised using MOSFET transistors.

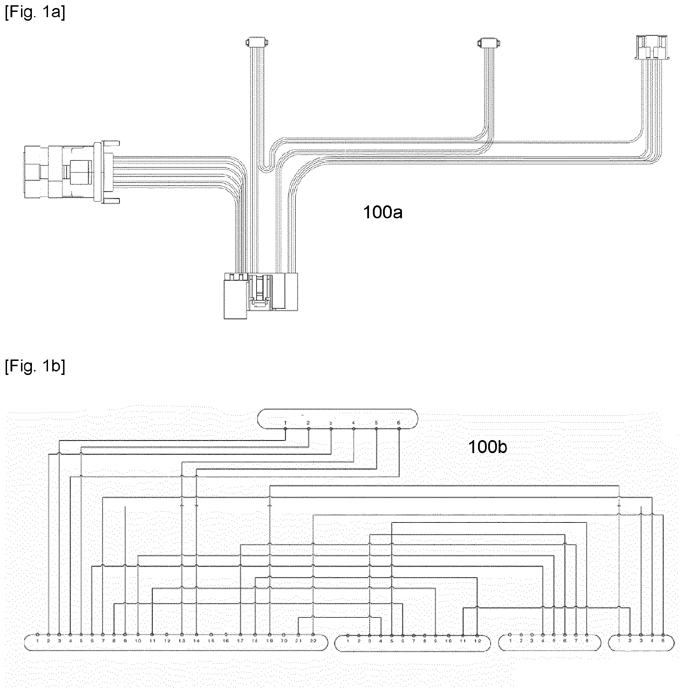

[Fig. 1a] shows an example of a wire harness 100a with its bundle of individual wires of different lengths laid out such that the various different connectors of the wire harness are physically disposed at convenient positions to be deployed and connected to their corresponding plugs or sockets within a vehicle system, for example. [Fig. 1b] shows an electrical schematic 100b corresponding to the wire harness of [Fig. 1a].

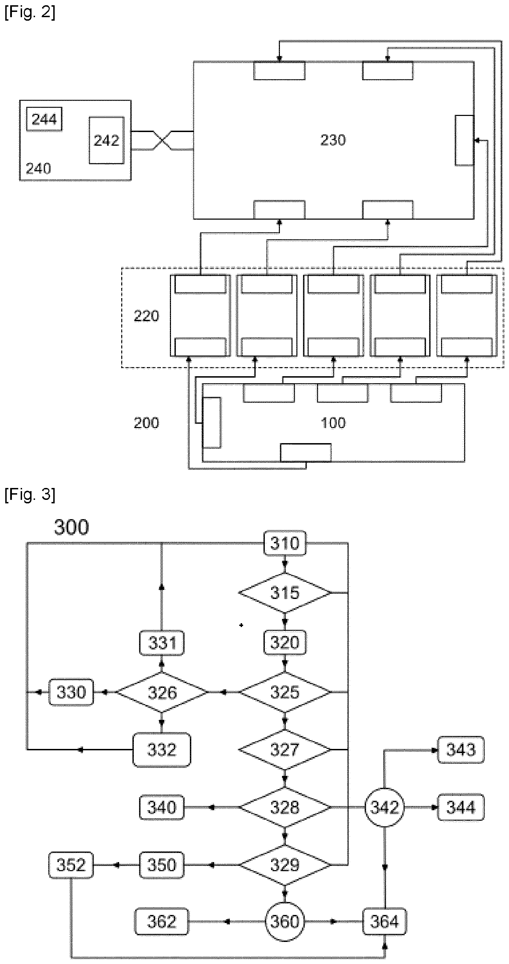

[Fig. 2] illustrates an automated wire harness diagnosis system 200 according to an embodiment described herein. The wire harness 100a with its wires and plugs and/or sockets is shown at the bottom of the figure. The automated wire harness diagnosis system 200 may comprise a harness interface subsystem 220 comprising a set of electrical connectors to which the different plugs or sockets of the wire harness 100a may be connected. The system 200 further comprises a load characterisation subsystem 240 configured to drive an electrical load and to measure certain electrical parameters of the electrical load so that measurements can be made in order to characterise the load. The system may further comprise a wire management subsystem 230 configured to organise one or more of the wires of the wire harness into a predetermined configuration to provide a suitable electrical load for the load characterisation subsystem. During operation, an electrical stimulus may thus be provided to the wire harness, conveniently configured via the harness interface subsystem, as a suitable electrical load and the behaviour of the harness in response to the electrical stimulus may be monitored and analysed.

The harness interface subsystem may be implemented as a set of customised adaptors which can plug into or which are soldered onto the circuit board on which the wire management subsystem is carried out in a manner that the various plugs and/or sockets of the wire harness can be conveniently connected to the wire management subsystem thus ensuring a set of robust connections between wire harness connectors and their PCB mate connectors on the wire management subsystem board.

[Fig. 3] shows a diagnosis protocol, or a test and validation protocol 300, which may be deployed in different embodiments described herein as part of a wire harness automated methodology for manufacturing wire harnesses. The protocol starts at step 310. A human operator or a machine may perform a preliminary visual inspection at step 315, which could already allow for an initial diagnosis 320 to be reached and a decision as to whether any of the electrical tests of the protocol should be performed.

Should the harness pass the optional preliminary visual inspection 315, the electrical diagnostic tests may commence. According to an embodiment, one or more electrical continuity tests 327 may be performed in order to determine whether there are any broken wires in the harness. The continuity test 327 may be performed according to any known DC continuity test, thus providing a fast health check on the harness.

Should the harness pass the continuity test, then as part of the diagnosis protocol, one or more resistance measurements 328 may be made on at least one wire of the harness. According to one embodiment, the resistance measurement may be performed on one wire at a time within a wire harness comprising a plurality of wires. According to another embodiment, the resistance measurement may be performed on a plurality of the wires at the same time. According to a particular embodiment, the resistance measurement may be performed on all of the wires within the wire harness when using a hardware system configured to present all of the wires in the harness chained into a configuration comprising all the wires of the harness connected in series between two test terminals.

Should the resistance measurement fall within a predetermined range, then the wire harness may be considered to have passed the resistance test and the diagnosis protocol may continue to the next step. Should the wire harness fail the resistance test, then the wire harness under test may be considered to be unfit for use. The test result may be documented and the protocol may come to an end for the harness under test. The test result may include the value of the resistance 340 which was measured, preferably to a high level of accuracy, for example to a resolution of down to fifty and up to a few hundreds of micro-ohms. A suitably configured software utility may be used to estimate a useful lifetime of the harness based on the comparison of resistance measurement results with intrinsic resistance values. Intrinsic resistance values of wires may be calculated based on certain physical and/or material properties of the wires. The measured value may then be compared to the intrinsic resistance to determine whether any deviation falls within a predetermined acceptable range.

Should the wire harness pass the resistance test 328, then the diagnosis protocol may proceed to a step of dynamic characterisation of the wire harness 329. During this step, an AC stimulus may be provided to the harness, where the spectral behaviour of the harness is assessed and its response may be documented. The response of the wire harness under test to the AC stimulus may be compared 350 with expected responses of compliant wire harnesses or harnesses which have certain defects. The AC stimulus may be one or more pulses or a continuous sinusoidal stimulus or other periodic stimulus provided at one end of the harness, while at the opposite end of the harness the response is captured and analysed. The AC response results may be used to estimate the useful remaining lifetime of the harness under test, especially when the analysis includes the use of machine learning algorithms to classify the results into potential fault modes. Spectral behaviour assessment enables signal degradation quantitative analysis in the harness due to effects produced by the capacitance, inductance and resistances present within the harness. Increased signal degradation observed in harnesses may usually be associated with unreliability of the harness and may suggest a shorter durability. Spectral behaviour analysis can lead to detection of faults caused by resistance, capacitance and inductance effects as well as cross-talk, discontinuity, connector degradation, mechanical damage and the like.

According to an embodiment, a convolutional neural network or other machine learning model, trained using datasets of different possible spectral and/or DC responses of both faulty and working harnesses, may be implemented at step 350 to analyse the wire harness response to an AC stimulus such as a pulsed waveform or a sinusoidal stimulus and to classify the results into different detected faults or qualities 352. At step 364, a report may be generated giving an estimation of the remaining lifetime in the wire harness. According to an embodiment, machine learning models may also be used to analyse the response to the DC stimulus and to estimate the remaining lifetime of the wire harness based on the response to the DC stimulus.

Optionally, before proceeding with the electrical tests and measurements, the protocol may include a procedure designed to ensure that various different parts of the hardware used for the testing are in optimum condition. For example, the protocol may include a condition 325 that after a predetermined number N of cycles of diagnostics testing, all or part of the diagnosis system may be sent for calibration 331. Furthermore, depending on whether a predetermined number M of cycles of diagnostics testing has been performed 326, the protocol may include a step of renewing one or more connectors of the harness interface subsystem 330 or renewing the wire management subsystem or parts thereof 332 before allowing any further stimulus and measurement steps to be performed. As illustrated in Figure 3, should the predetermined number N of cycles of diagnostics testing be reached or exceeded, then according to an embodiment of the protocol, parts of the test hardware may be replaced and the test restarted.

For embodiments in which the resistance measurement is performed on a plurality of wires at the same time, the wire management subsystem may be a serialisation circuit, configured to allow a plurality of wires from the harness to be appropriately organised to make such a measurement possible. Serialisation circuits according to embodiments described herein allow for a plurality of wires of the harness, preferably substantially all of the wires of the harness, to be electrically configured to provide a single series connection of wires having a first terminal at a first end of the serialisation circuit into which a test current may be forced and a second terminal at a second end of the serialisation circuit through which the test current may be recovered. Thus, the harness, when connected across the first and second terminals of the serialisation circuit, in combination with the serialisation circuit itself, presents a passive electrical load for a tester providing the test current. By measuring a voltage across the first and second terminals of the serialisation circuit while the tester provides the test current, it is then possible for the tester to calculate the resistance of the passive load. It may be possible also to deduce the resistance of the harness.

Thus, in certain embodiments, the wire management subsystem may be called a serialisation circuit, which could be implemented on a printed circuit board for example. This serialisation board thus interconnects all wires within the harness through their designated connectors. Each wire, possessing two ends, establishes continuity by linking the second end of one wire to the first end of the subsequent wire via wire-to-board or mate connectors. This sequence repeats for all wires. Subsequently, a connector on the serialisation board facilitates access to the first end of the initial wire and the second end of the terminal wire, enabling a connection to the load characterisation subsystem, which may be implemented as a separate printed circuit board, the connector being preferably an RF connector.

The use of a serialisation circuit allows for simultaneously testing all wires and connectors within the harness, resulting in significant time efficiency in running the test and validation process. This allows for the process to be accelerated by a factor of at least the total number of wires in the harness. Without the serialisation circuit, each wire and connector of the harness would have to be tested separately, substantially increasing the time and effort required for the test and validation process.

As mentioned before, figure 2 shows an example of a wire harness being connected via a harness interface subsystem to a load characterisation subsystem via a wire management subsystem in the form of a serialisation board. Under certain particular circumstances, where the harness design does not include a wire splice box, the design of the serialisation board, or serialisation circuit, is rather straightforward, requiring only a single electrical path based on the wire harness topology to allow for the tests to be conducted. However, in harness models which do include wire splices, the existence of multiple alternate electrical paths means that the wire harness topology needs to be very carefully considered in order to come up with an appropriate serialisation circuit design. In such cases, manual or automatic switches may need to be included in the serialisation circuit to allow the individual tests on these paths to be adequately performed.

According to an embodiment, a controller may be provided for controlling the load characterisation subsystem to perform the automated diagnosis according to the protocol. In some embodiments, the controller may be implemented as a microprocessor on the same circuit board as the load characterisation subsystem. Otherwise, the controller may be on a separate board from the load characterisation subsystem. In some embodiments a general-purpose computing unit may be programmed to perform the analysis of the measured data. The general-purpose computing unit may be programmed to analyse the measured data using machine learning techniques based on models trained using data sets of responses of different types of harnesses presenting different types of faults as well as fully functional harnesses.

According to an embodiment, the general-purpose computing unit, for analysing the response of the test harness to the stimulus provided by the load characterisation subsystem, may be included within a data analysis subsystem within the automated wire harness diagnosis system.

The top left part of figure 2 shows the wire management subsystem, or serialisation board, being connected to the load characterisation subsystem. The load characterisation subsystem assumes a pivotal role in executing the test and validation protocol within the designated timeframe. Additionally, it facilitates communications necessary for computer software in the computing unit to seamlessly acquire, analyse, visualise, and store measurement data.

The continuity checks performed at step 327 of figure 3 may be performed in a straightforward manner by the load characterisation subsystem. For example, a low-voltage Transistor-Transistor Logic signal (LVTTL) may be applied to one end of the wire harness via the serialisation board. The microcontroller, at the opposite end, may then monitor for the corresponding voltage level. Successful continuity detection occurs when the microcontroller identifies the expected voltage level, signifying that the continuity test has passed. Conversely, failure is indicated if the detected voltage deviates from the expected level.

The resistance measurements 328 which are carried out according to one or more embodiments, allow for high precision measurements to be achieved in a short time. This is facilitated by the load characterisation subsystem being configured to provide a test current, preferably a substantially constant current to drive the wire harness. The voltage drop across the wire harness may then be measured in order to calculate the resistance of the wire harness. The load characterisation subsystem, comprising the source of the test current and further comprising voltage measurement means, is preferably a precision resistance measurement system, capable of measuring resistances in the range of hundreds of micro-ohms. In some embodiments, the resistance measurement system is capable of measuring resistances with a resolution, as little as fifty micro-ohms. Advantageously, the resistance measurement system may be configured to accurately and reliably measure the resistance on the harness within a short time interval and so is configured to minimise the possibility of potential ringing or overshoots and undershoots or involvement of voltage regulation ripples during the measurement. Whereas known resistance measurement modules use a simple, cost-effective means comprising a comparator with a single op-amp for voltage and current regulation, the load characterisation subsystem in embodiments described herein comprise analogue circuitry designed to provide smooth adjustments in current, thus avoiding overshoots and undershoots when the circuit reacts to a step change for example, allowing for greater precision and greater dynamic range and leading to a more precise characterisation of the wire harness. The use of machine learning techniques to treat the data gathered from the measurement process enables efficient and accurate classification of detailed characterisation of the harness with statistically sound predictions as to the useful lifetime of the harness. The current source in the load characterisation subsystem comprises a MOSFET based current mirror in order to ensure a substantially constant current over a large range of output voltages. When the MOSFETs of the current mirror operate in their saturation region, as is the case in the proposed current mirror configuration, a substantially constant current can be maintained even though the drain to source voltage of the MOSFET varies. This means that in operation, when used to provide a known current for measuring the resistance of a load, a substantially constant current can be maintained over a large dynamic range. This provides for excellent current stability over a large range of drain-source voltages.

According to a particular embodiment, a DC power supply system is provided in the load characterisation subsystem, in which a switching stage is provided using a PID mechanism to control the output voltage. Control of the output voltage is provided using a PWM mechanism, whose duty cycle is adjustable, to set the switching of the PID mechanism to maintain the output current at the desired output voltage, with minimal deviation-induced fluctuations.

Using such a switching DC power supply, equipped with a switching stage having a PID controller, provides for a sophisticated and refined control means using analogue technology. Such an effectively analogue PID algorithm, encompassing proportional, integral, and derivative terms, ensures a smooth and precise response over a wide range of different load values, thus avoiding abrupt changes (e.g., overshoots and/or undershoots) in output voltage and/or current over the short time of the measurement while the enable switch is activated in the current mirror circuit. Despite the potential additional complexity and cost, the advantages in precision, adaptability, and reduced control-induced variations make this approach suitable for applications demanding a higher level of control sophistication.

The assessment of a wire harness's health relies, at least in part, on the indicative parameter of electrical resistance within its wires and connectors. Lower resistance implies enhanced conductivity, while elevated resistance could indicate a potential risk of one or more wires overheating, which could even lead to a vehicular fire in the presence of high currents. Throughout its lifetime, a harness's reliability can be influenced by certain effects due to oxidation, corrosion, or partial cuts, all of which may contribute to increased electrical resistance. Consequently, measuring the electrical resistance of a wire harness and comparing deviations from the norm are extremely useful in evaluating the harness's quality and for gauging its remaining durability.

The amount of resistance in harness wires and connectors may be affected by various factors, including the conductive material, the length and cross-sectional area of the wires etc. For instance, a contemporary car's cumulative length of electrical wires may exceed four kilometres. Typically however, within a harness, the length of any given wire generally does not exceed a few metres. Consequently, achieving a high dynamic range, sensitivity, and measurement accuracy becomes of prime importance in accurately and effective quantification of wire resistance.

A current mirror configuration is employed in embodiments of the load characterisation subsystem to furnish the required current to stimulate the wire harness. This type of configuration allows for precise control of electrical current in an active device, independent of its load, through another active device. This ensures a consistent current, irrespective of loading conditions, with the load here represented by the resistance of the wire harness.

An additional advantage of employing the current mirror configuration as a current source lies in the minimal impact of voltage levels on the performance of each active device. This feature grants flexibility in selecting the desired voltage level, which is particularly beneficial when connecting a analogue to digital converter to the circuit for acquisition of measurement voltages.

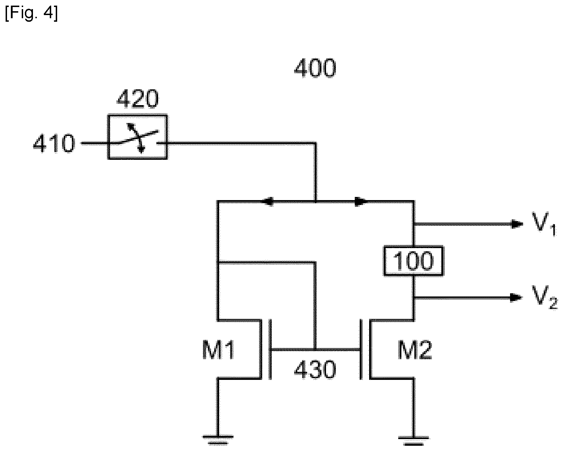

[Fig 4] shows an example of an adjustable current source 400 comprising a MOSFET current mirror configuration as part of the load characterisation subsystem for use in the electrical resistance measurement of the wire harness according to an embodiment. A tunable power supply 410, incorporating a current-limiting control loop, is employed to provide precise current control through a PID loop. This allows for an extremely accurate and stable current to be provided during the test and validation of the wire harness. The tunability of the adjustable power supply extends equally to both its current supply capacity and its voltage output over a very broad range of values.

The current from the tunable power supply can be switched 420 onto the master and mirror branches of the current mirror 430 represented by appropriately configured MOSFETS M1 and M2. The switching may be controlled by the controller. On the mirror branch of the current mirror two terminals are provided, across which the load to be analysed, i.e. the harness 100, may be connected. In embodiments where a serialisation board is used, the entire collection of wires within the harness is presented in series across the terminals. Analogue to digital converters may be used at points V1 and V2 to measure the voltage across the load while it being driven from the current source.

By way of example, the output current may be in the order of 1A. For a 3.3V voltage drop across the harness, if using 12-bit ADCs to measure the voltage, providing 2 to the power of 12, equal to 2096, possible output values, it would be possible to measure the resistance of the harness to a resolution of around 800 micro-ohms. If 16-bit ADCs were to be used instead, then the resolution would be in the order of 50 micro-ohms.

The current mirrors, as they are employed in embodiments described herein, offer a broad range of current adjustability, providing the flexibility to supply higher current for measuring the smaller resistances typical of shorter wire harnesses found in smaller vehicles while also being able to supply lower current for assessing higher resistances typical of those encountered in larger vehicles with lengthier wire harnesses. This extensive range of adjustability ensures precise control, sensitivity, and accuracy in resistance measurements, allowing for a suitable estimation of the remaining lifetime of wires and connectors within the harness, considering deviations from the nominal values.

The use of two analogue to digital converters to read voltages at each of terminals V1 and V2 for calculating the resistance of the load presented by the harness amounts to the accomplishment of a differential measurement, which bolsters the robustness of the system with respect to its immunity to common mode noise, thereby again improving overall precision of the system.

According to an embodiment, it is possible for substantial amounts of current to be provided by the current source. Provision for heat management is made and may be switched in or out depending on the level of current sensed in the current source circuit.

As aforementioned, the diagnosis protocol is designed to favour the recovery and remanufacturing processes of wire harnesses, extending beyond the realm of simple manufacturing. This comprehensive approach is made possible through the integration of machine learning techniques, specifically the utilisation of Convolutional Neural Networks (CNN) incorporating a trained model as part of the protocol. This sophisticated integration empowers the protocol with a remarkable ability to estimate the degradation effects induced by the prior utilisation of wire harnesses.

The machine learning technology employed in the embodiments described herein plays a significant role by identifying and attributing the most probable reasons for failures, offering valuable insights into the operational lifetime estimation of the used wire harness system. This advanced analytical capability enhances the system's adaptability and reliability, ensuring a nuanced understanding of the wire harness's condition and facilitating informed decision-making during the recovery and remanufacturing processes.

The protocol is designed with a primary focus on recycling. Examining wire harnesses' environmental, economic, and safety aspects guide exploring sustainable practice, contributing to a more sustainable and circular economy approach to wire harness utilisation.

## Claims

1. An automated wire harness diagnosis system (200) for diagnosing faults and/or for estimating a residual useful lifetime of a wire harness (100) comprising a plurality of different wires for carrying power or electrical signals and one or more wire terminals or wire terminal groups at the ends of the plurality of wires, the automated wire harness diagnosis system (200)comprising:
- a harness interface subsystem (220) comprising a set of connectors configured to receive connection from at least one of the wire terminals or wire terminal groups of the wire harness (100);
- **characterised in that** the system (200) further comprises:
- a load characterisation subsystem configured to provide an electrical stimulus to an electrical load across a test port of the load characterisation subsystem and to monitor a response of the electrical load to the electrical stimulus;
- a controller configured to control at least the load characterisation subsystem (240) according to a predetermined automated wire harness diagnosis protocol (300); and
- a wire management subsystem (230) configured to organise a plurality of the wires of the wire harness (100) into a predetermined configuration to provide a suitable electrical load for the load characterisation subsystem (240), said predetermined configuration resulting in the plurality of wires being electrically connected in series with each other at the test port.

2. The automated wire harness diagnosis system (200) according to claim 1, wherein said wire management subsystem (230) is configured to organise all of the wires of the wire harness (100) such that they provide an electrical load at the test port, the electrical load comprising all of the wires of the wire harness (100) connected in series with each other.

3. The automated wire harness diagnosis system (200) according to either of claims 1 or 2, wherein the load characterisation subsystem (240) is configured to provide a DC electrical stimulus at the test port.

4. The automated wire harness diagnosis system (200) according to either of claims 1 or 2, wherein the load characterisation subsystem (240) is configured to provide an AC electrical stimulus at the test port.

5. The automated wire harness diagnosis system (200) according to any of the preceding claims, further comprising a data analysis subsystem to analyse the response of the test harness to the stimulus provided by the load characterisation subsystem (240).

6. The automated wire harness diagnosis system (200) according to claim 5, wherein said data analysis subsystem comprises a machine learning algorithm for classifying the responses of the harnesses into different fault modes.

7. The automated wire harness diagnosis system (200) according to claim 6, wherein the data analysis subsystem is further configured to report a useful remaining lifetime of the harness under test (100) based on the fault mode exhibited by the harness under test (100).

8. A method for diagnosing faults and/or for estimating a residual useful lifetime of a wire harness (100) comprising a plurality of different wires for carrying power or electrical signals and one or more wire terminals or wire terminal groups at the ends of the plurality of wires using the system (200) according to any of the preceding claims, the method comprising:
- connecting all of the wire terminals or wire terminal groups of a wire harness to be tested (100) to the connectors of the harness interface subsystem (220);
- connecting the harness interface subsystem (220) to the wire management subsystem, said wire management subsystem (230) being configured to present an electrical load at the test port, the load comprising all of the wires of the wire harness (100) presented in an end to end series configuration of the wires;
- connecting the test port of the wire management subsystem (230) to the test port of the load characterisation subsystem (240);
- programming the load characterisation subsystem (240) to provide an electrical stimulus at the test port; and
- monitoring the response of the electrical load provided by the harness under test (100) at the test port.

9. The method according to claim 8, wherein said electrical stimulus is a DC stimulus.

10. The method according to claim 8, wherein said electrical stimulus is an AC stimulus.

11. The method according to either of claims 9 or 10, the method further comprising classifying the electrical response of the harness to the stimulus using a suitably trained machine learning model to provide said diagnosis.
